# FASCICULE DE BREVET EUROPEEN

(11) **EP 0 730 671 B1**
(45) Date de publication et mention de la délivrance du brevet: **17.10.2001**
(21) Numéro de dépôt: 94922896.9
(22) Date de dépôt: 08.07.1994
(51) Int. Cl.: C23C 16/44, B01D 1/18

(54) **PROCEDE ET DISPOSITIF D'INTRODUCTION DE PRECURSEURS DANS UNE ENCEINTE DE DEPOT CHIMIQUE EN PHASE VAPEUR**
VERFAHREN UND VORRICHTUNG ZUM ZUFÜHREN VON VORLÄUFVERBINDUNGEN IN EINEN CVD - REAKTOR
METHOD AND DEVICE FOR FEEDING PRECURSORS INTO A CHEMICAL VAPOUR DEPOSITION CHAMBER

(30) Priorité: 12.07.1993 FR 9308838
(43) Date de publication de la demande: 11.09.1996
(73) Titulaire: CENTRE NATIONAL DE LA RECHERCHE SCIENTIFIQUE (CNRS), 75700 Paris Cedex 07 (FR)
(72) Inventeur: SENATEUR, Jean-Pierre, F-38240 Meylan (FR); MADAR, Roland, F-38320 Eybens (FR); WEISS, François, F-38330 Montbonnot (FR); THOMAS, Olivier, F-13006 Marseille (FR); ABRUTIS, Adulfas L.M.G.P.ENS de Phys. de Grenoble, F-38402 Saint-Martin-d'Hères Cédex (FR)
(74) Mandataire: de Beaumont, Michel
(86) Numéro de dépôt international: FR9400858
(87) Numéro de publication internationale: WO9502711

(56) Documents cités:
- EP-A- 0 334 982
- EP-A- 0 453 107
- EP-A- 0 548 990
- GB-A- 1 120 650
- DATABASE WPI Section Ch, Derwent Publications Ltd., London, GB; Class C01, AN 92-147506 & JP,A,4 089 378 (CHODENDO HATSUDEN) 23 Mars 1992

## Description

La présente invention concerne les procédés et dispositifs de dépôt de couches minces par dépôt chimique en phase vapeur (CVD), éventuellement à basse pression (LPCVD).

Selon le procédé dit CVD, les éléments chimiques à déposer sont transportés directement ou sous forme de composés gazeux (précurseurs) vers une enceinte de dépôt où est placé un substrat sur lequel doit s'effectuer le dépôt. Le mélange est introduit dans une zone où se produit la réaction, activée par un apport d'énergie (élévation de température, plasma, photons, ...) qui donne en général un seul composé solide. Les résidus gazeux sont évacués hors du réacteur.

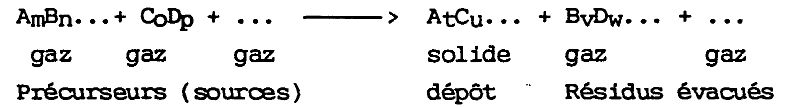

Le procédé utilise généralement autant de sources qu'il y a d'éléments dans le composé à synthétiser. Un ou plusieurs gaz vecteurs, qui peuvent être neutres ou participer à la réaction, assurent l'entraînement des vapeurs des précurseurs jusqu'à la zone de dépôt.

Dans le procédé CVD, l'un des problèmes qui se posent réside dans l'introduction des précurseurs dans l'enceinte de dépôt.

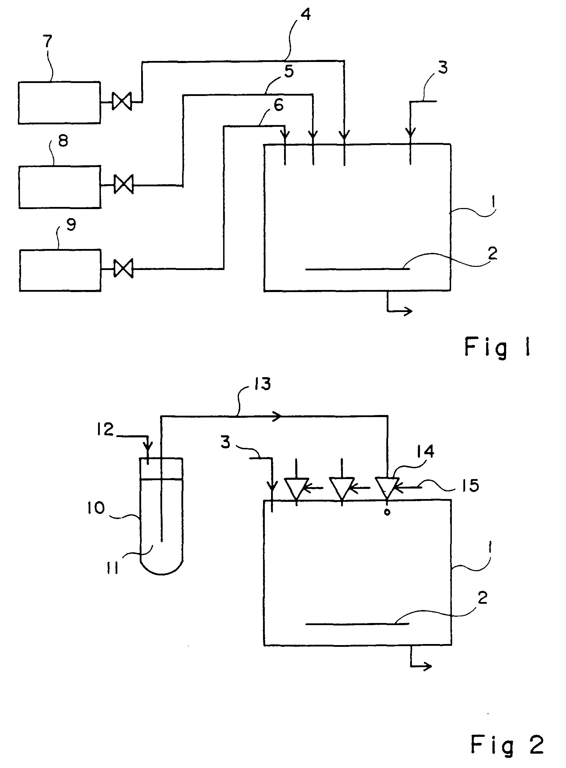

La figure 1 ci-jointe illustre très schématiquement le problème à résoudre. Une enceinte 1 est maintenue à une température et une pression propres à permettre la réaction de dépôt sur un substrat 2 généralement chauffé. Dans cette enceinte débouchent une ou plusieurs conduites 3 d'introduction de gaz vecteurs diluants ou réactifs et des conduites 4, 5, 6 d'introduction des précurseurs gazeux dans l'enceinte.

Si les précurseurs sont eux-mêmes initialement gazeux à température ambiante, il y a peu de problème. Si les précurseurs sont liquides ou solides, il est nécessaire de les chauffer dans des réservoirs 7, 8, 9 pour les volatiliser et atteindre ainsi une tension de vapeur suffisante pour assurer le transport de la matière par un gaz vecteur.

Dans le cas particulier où une ou plusieurs sources solides ou liquides sont utilisées, il est nécessaire de stabiliser parfaitement la température et le débit du gaz vecteur de chaque source pour fixer la composition du dépôt. Ainsi, pour un composé comprenant n éléments, il faut contrôler pour chaque source la température et le débit, c'est-à-dire 2n paramètres. De plus, quand on chauffe un solide sous forme de poudre pour le vaporiser, sa surface d'évaporation peut souvent être bloquée par des impuretés ou par oxydation par des traces d'humidité dans le gaz vecteur si bien que cette surface évolue et que le rendement n'est pas constant. Cette surface varie également au fur et à mesure de la consommation de la source solide. En outre, dans le cas de solides présentant des températures de sublimation très élevées, cette température doit être maintenue dans toute la canalisation conduisant de la source à l'enceinte. Ceci pose plusieurs problèmes, d'une part des problèmes fondamentaux de possible décomposition de précurseurs instables dans la source et lors de leur trajet de la source à l'enceinte de dépôt, d'autre part des problèmes techniques de réalisation de vannes capables de supporter des hautes températures.

Pour résoudre ces problèmes, diverses solutions ont été proposées dans la technique.

Une première solution a consisté à prélever régulièrement de faibles quantités de poudre de précurseurs à l'état solide et à les introduire directement dans l'évaporateur où elles sont instantanément volatilisées. Ce procédé permet d'obtenir un débit de vapeur contrôlé même avec des précurseurs thermiquement instables puisque seule la quantité de précurseur prélevée est portée à haute température dans l'enceinte de dépôt après introduction dans cette enceinte. On comprendra toutefois que ce procédé présente notamment les inconvénients suivants.
- Il est très difficile de doser avec précision l'injection de quantités régulières de poudre. Ceci nécessite un contrôle parfait de la granulométrie et la réalisation d'un système capable d'injecter de micro quantités de poudres (quelques 10⁻⁶ g de poudre par injection).
- Les systèmes de dosage de poudres sont trop imprécis pour permettre d'utiliser plusieurs injecteurs de solides en parallèle pour la synthèse de composés comprenant plusieurs éléments. Pour l'injection simultanée de plusieurs précurseurs, il est nécessaire d'utiliser des mélanges de poudres parfaitement homogènes (tant sur le plan de la composition que sur celui de la granulométrie) ce qui pose un problème technique difficile à résoudre.
   Une deuxième solution a consisté à faire appel à des procédés de nébulisation. Les précurseurs liquides ou solides dissous dans un solvant, afin d'obtenir une source liquide, sont transformés en aérosol par nébulisation ultrasonore. L'aérosol est transporté jusqu'à la zone de dépôt par un gaz vecteur neutre ou actif. Différents précurseurs liquides ou en solution peuvent être mélangés avant transformation en aérosol. Il n'y a en général qu'une seule source, bien qu'il soit possible d'envisager plusieurs générateurs d'aérosol en parallèle. L'avantage de ce procédé par rapport à la CVD classique est que le rapport des concentrations des différents éléments apportés en zone de dépôt reste constant au cours du temps s'il n'y a qu'une seule source. Seul le débit total peut varier si la viscosité de la solution varie. On comprendra toutefois que ce procédé présente notamment les inconvénients suivants.
- La production ultrasonore de l'aérosol entraîne un échauffement de la solution, d'où une variation de viscosité. Il est donc très difficile de stabiliser la production d'aérosol (ce qui explique qu'il n'y ait en général qu'une seule source et que, si un système multisources est envisageable, il est très rarement utilisé). Le système est difficilement applicable à la réalisation de multicouches alternées en une seule opération.
- L'excitation ultrasonore nécessaire à la génération de l'aérosol peut, dans certains cas, activer une réaction chimique entre les précurseurs et, éventuellement, le solvant d'une solution. Ceci entraîne une modification des quantités de précurseurs apportées en zone de réaction, ce qui est très nuisible à la qualité du dépôt.
- Il est nécessaire d'utiliser des liquides ou solutions peu visqueux pour permettre leur nébulisation. Ceci implique l'utilisation de solvants très fluides et de solutions en général diluées, donc des pressions partielles de vapeur de précurseurs faibles au niveau du substrat.
- Les solutions utilisées étant nécessairement diluées pour des raisons de viscosité, il existe de grandes quantités de solvant dans la phase gazeuse dans la zone de réaction. Ces quantités importantes de vapeur de solvant au niveau du substrat peuvent conduire à des réactions parasites nuisibles à la qualité des dépôts.
- Dans de nombreux cas, le gaz vecteur participe à la réaction (exemple : oxygène ou air pour le dépôt d'oxydes, ammoniac pour le dépôt de nitrures, hydrogène sulfuré pour le dépôt de nitrures). Le mélange d'un gaz réactif et de quantités importantes de solvant organique peut entraîner des réactions explosives dans le réacteur. Il est possible de limiter ces risques d'explosion en travaillant à basse pression, mais il est nécessaire alors d'utiliser un solvant à basse tension de vapeur pour éviter l'ébullition des sources. La nécessité d'avoir des solvants à basse tension de vapeur et faible viscosité limite considérablement le choix des solvants utilisables.

EP-A-0 548 990 décrit un moyen d'injection d'un flux continu de gouttelettes identiques dans une enceinte de dépôt.

Ainsi, un objet principal de la présente invention est de prévoir un système d'introduction de précurseurs de dépôt dans une enceinte de dépôt CVD qui pallie les inconvénients des procédés antérieurs et qui soit particulièrement simple à mettre en oeuvre.

Un objet plus particulier de la présente invention est de prévoir un tel système dans lequel on obtient une excellente stabilité de la tension de vapeur des précurseurs en zone de dépôt mélangés ou séparés de vapeurs de solvants (même avec des précurseurs thermiquement instables).

Un autre objet particulier de la présente invention est de prévoir un tel système qui présente un coût minime en utilisant une installation faisant appel à des composants fluidiques classiques et bien au point.

Un autre objet particulier de la présente invention est de prévoir un tel système qui permette la réalisation simple de systèmes multicouches ou de couches à gradients de composition.

L'invention s'applique a tous précurseurs liquides ou en solution et en particulier au cas où certains au moins des éléments intervenant dans la réaction de dépôt sont des éléments à température de sublimation élevée (500 à 1000°C).

Pour atteindre les objets susmentionnés, la présente invention prévoit un procédé d'introduction dans une enceinte de dépôt chimique en phase vapeur d'éléments à déposer sur un substrat chaud ou de précurseurs de ces éléments, comprenant les étapes consistant à maintenir le ou les précurseurs liquides ou en solution à une pression plus élevée que celle de l'enceinte, injecter périodiquement dans l'enceinte de dépôt des gouttelettes de volume déterminé desdits précurseurs, et entraîner vers le substrat les précurseurs volatilisés à la température et à la pression de l'enceinte.

La présente invention prévoit aussi un dispositif d'introduction dans une enceinte de dépôt chimique en phase vapeur de précurseurs du ou des éléments à déposer sur un substrat chaud, comprenant au moins un réservoir contenant le ou les précurseurs liquides ou en solution, des moyens pour maintenir le réservoir à une pression plus élevée que celle de l'enceinte, au moins un injecteur associé à chaque réservoir muni de moyens de commande pour injecter périodiquement dans l'enceinte de dépôt des gouttelettes de volume déterminé des précurseurs, et des moyens pour entraîner les produits injectés vers un substrat situé dans l'enceinte de dépôt.

Selon un mode de réalisation de la présente invention, ce dispositif comprend un porte substrat chauffé.

Selon un mode de réalisation de la présente invention, l'enceinte de dépôt comprend une plaque chauffée sur laquelle sont projetées les gouttelettes.

Selon un mode de réalisation de la présente invention, l'enceinte de dépôt est divisée en deux parties par un matériau poreux.

Selon un mode de réalisation de la présente invention, l'enceinte de dépôt est divisée en une première partie constituant un évaporateur et une deuxième partie à plus haute température constituant une chambre de dépôt.

Selon un mode de réalisation de la présente invention, les moyens pour entraîner les produits injectés comprennent des moyens d'injection de gaz vecteur situés dans une zone intermédiaire de la chambre de dépôt entre l'injecteur et le substrat pour entraîner, en association avec une pompe située derrière le substrat, les précurseurs gazéifiés vers ce substrat et pour faire refluer les parties rapidement évaporées du solvant des gouttelettes vers un évent.

Ces objets, caractéristiques et avantages ainsi que d'autres de la présente invention seront exposés en détail dans la description suivante de modes de réalisation particuliers faite en relation avec les figures jointes parmi lesquelles :
la figure 1, décrite précédemment, illustre très schématiquement l'allure d'un système classique d'introduction de précurseurs de dépôt dans une enceinte de dépôt CVD ;
la figure 2 illustre très schématiquement l'allure d'un système d'introduction de précurseurs de dépôt dans une enceinte de dépôt CVD selon la présente invention ; et
la figure 3 représente de façon un peu plus détaillée un mode de réalisation d'un système d'introduction de précurseurs de dépôt dans une enceinte de dépôt selon la présente invention.

Comme l'illustre très schématiquement la figure 2, la présente invention consiste à prévoir dans un ou plusieurs réservoirs sous pression 10 un précurseur liquide 11 ou une solution de précurseurs solides. La température dans ce réservoir est choisie pour une conservation optimale et une non-réactivité des précurseurs. La pression peut par exemple résulter de l'introduction dans la partie supérieure du réservoir 10 d'un gaz sous pression 12 pour maintenir une pression élevée, par exemple de l'ordre de 1 à 5 fois la pression atmosphérique. Le liquide 11 dans le réservoir 10 est convoyé par une conduite 13 vers l'entrée d'un injecteur commandé 14 comprenant une entrée de commande 15 contrôlée par exemple par un système à microprooesseur. L'injecteur 14 est du type permettant d'injecter à chaque actionnement une gouttelette de liquide de volume parfaitement contrôlé et reproductible. On pourra par exemple choisir un simple injecteur de moteur thermique à essence ou diesel d'automobile.

Dans l'enoeinte de dépôt 1, un ou plusieurs gaz vecteurs sont introduits par la conduite 3 pour entraîner les précurseurs, vaporisés à la pression et à la température de cette enceinte, vers le substrat où ils vont se déposer par la réaction de dépôt chimique en phase vapeur classique, éventuellement assistée par activation thermique, par plasma, par photons....

Les avantages du procédé et du dispositif selon l'invention par rapport aux procédés et dispositifs de l'art antérieur sont nombreux. On notera en particulier les avantages suivants.

Selon un premier avantage, le précurseur liquide ou la solution de précurseurs solides 11 est maintenu sous une pression de gaz neutre éventuellement très pur. De plus, dans le réservoir 10, la conduite 13 et l'injecteur 14, ce liquide ou cette solution peut être maintenu à une température choisie (et non pas à la température élevée de l'enceinte 1). Si l'on appelle évaporateur la zone haute de l'enceinte de dépôt, ce liquide est isolé de l'évaporateur par le clapet de l'injecteur et la pression d'entrée de l'injecteur peut être de plusieurs atmosphères. Pour que l'injection soit assurée, la seule condition sur la pression dans l'évaporateur est qu'elle soit inférieure à celle qui règne dans le réservoir, la conduite 13 et l'injecteur 14.

Selon un deuxième avantage de la présente invention la quantité de précurseur injectée par unité de temps reste constante et peut être réglée avec précision en agissant sur l'un ou l'autre de plusieurs paramètres :
- le volume de la goutte injectée est contrôlé par la différence de pression entre l'évaporateur et l'injecteur ou par le temps d'ouverture de l'injecteur, contrôlable avec une très grande précision par un microprocesseur ;
- la quantité de précurseur injectée par unité de volume de la goutte peut être réglée par la concentration de la solution ;
- la quantité de liquide injectée par unité de temps peut être réglée par la fréquence d'ouverture de l'injecteur.

Selon un troisième avantage de la présente invention, la réaction peut être obtenue ou bien en utilisant un seul injecteur recevant un mélange des précurseurs liquides ou de leur solution dans un solvant ou bien, pour la synthèse de composés comportant plusieurs éléments, la réaction peut être obtenue par injections successives, simultanées ou intercalées de différents précurseurs à partir de plusieurs injecteurs.

Selon un quatrième avantage de la présente invention, l'utilisation de plusieurs injecteurs ouverts successivement pendant des temps égaux ou différents avec des solutions de dilutions égales ou différentes permet de réaliser sans systèmes d'évents complexes des dépôts multicouches d'épaisseur facilement contrôlée.

Selon un cinquième avantage de la présente invention, les précurseurs peuvent être maintenus dans l'injecteur dans des conditions de température et de pression où ils sont stables. Il n'y a pas d'apport d'énergie thermique ou ultrasonore dans l'injecteur, ce qui limite la possibilité de réactions parasites dans la source. Les précurseurs ne sont transformés en vapeur que pendant le temps très bref qui sépare l'injection de la réaction. Seule une très faible quantité de précurseur est volatilisée à chaque injection, ce qui assure la stabilité de l'apport de matière en zone de dépôt au cours du temps, même pour des précurseurs thermiquement instables.

Selon un sixième avantage de la présente invention, les liquides et/ou solvants utilisés peuvent être très volatils et relativement visqueux. Les solutions peuvent être très concentrées.

Selon un septième avantage de la présente invention qui ressortira plus particulièrement de la description ci-après, si on utilise des solvants très volatils, ceux-ci se volatilisent dans l'évaporateur au voisinage de l'injecteur avant les précurseurs. On peut alors éliminer les vapeurs de solvants par un entraînement gazeux à contre sens. Les précurseurs libérés (solides ou liquides) peuvent être entraînés par sédimentation naturelle ou par un procédé mécanique (gaz ou solide) dans une zone plus chaude où ils seront transformés en vapeur. Celle-ci, entraînée par un gaz vecteur neutre ou actif, sera utilisée dans la réaction de dépôt suivant un processus identique à la CVD classique. Ceci permet de résoudre le problème des sources solides pour la CVD. A titre d'exemple de système mécanique, les gouttelettes injectées peuvent être projetées sur une roue, une bande convoyeuse ou analogue qui les transporte dans l'évaporateur entre une zone initiale d'évaporation des solvants et une zone d'évaporation des précurseurs proche du site de réaction. Dans la zone initiale, le flux gazeux à contre sens élimine le solvant évaporé.

Selon un huitième avantage de la présente invention, la quantité de précurseur injectée par unité de temps peut être parfaitement maîtrisée par la fréquence des injections, la taille des gouttelettes, ou la dilution de la solution, ce qui permet un contrôle très souple de la vitesse de croissance. Il est possible d'obtenir des pressions partielles de gaz réactifs très faibles (vitesse de croissance très lente) ou des pressions partielles considérables (vitesse de croissance très élevée). L'injection peut être effectuée dans une zone très proche du substrat. Le temps de transport des précurseurs sous forme vapeur est alors très bref, ce qui permet de les surchauffer largement au delà de leur température de décomposition et d'obtenir des réactions de dépôt avec des pressions partielles de vapeur impossibles à atteindre avec les procédés classiques.

Enfin, comme l'injection peut être effectuée au voisinage immédiat du substrat, il n'est pas nécessaire d'utiliser, comme dans le procédé classique, des conduites et des vannes chaudes entre les sources et la zone de dépôt.

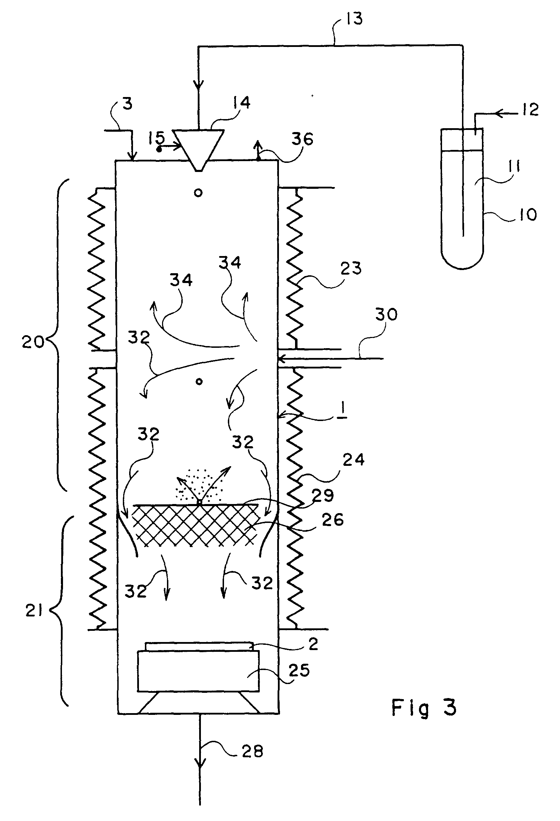

La figure 3 représente de façon un peu plus détaillée un exemple de réalisation d'un système d'injection associé à une enceinte de dépôt CVD selon la présente invention.

Dans cette figure, les références 10 à 15 désignent de mêmes éléments qu'en figure 2. L'enoeinte de dépôt 1 est séparée en deux zones 20 et 21 que l'on qualifiera respectivement d'évaporateur et de réacteur. Des moyens de chauffage permettent d'entretenir un gradient de température choisi dans l'enceinte de dépôt. A titre d'exemple, on a montré un chauffage par deux systèmes de résistances chauffantes pour, par exemple, maintenir la partie haute de l'évaporateur à une température de l'ordre de 60° et la partie basse de l'évaporateur et le réacteur à une température de l'ordre de 300°. Le substrat 2 est placé sur un support chauffant 25 régulé à la température de dépôt choisie, par exemple de l'ordre de 600 à 1100°C. Dans le mode de réalisation représenté, uniquement à titre d'exemple, la zone d'évaporateur 20 est séparée de la zone de réacteur 21 par un séparateur poreux 26, par exemple en paille d'acier, servant à une meilleure répartition des gaz et éventuellement permettant d'entretenir un léger gradient de pression entre la zone d'évaporateur et la zone de réacteur. La partie basse du réacteur est reliée à une conduite de pompage 28 associée à une vanne à débit réglable destinée à entretenir dans le réacteur une pression choisie, par exemple une pression comprise entre le dix millième de la pression atmosphérique et plusieurs fois la pression atmosphérique.

Un gaz vecteur, participant ou non selon les besoins à la réaction, est également introduit dans l'enceinte 1 et assure notamment l'entraînement des précurseurs injectés vers le substrat. Ce gaz vecteur peut être introduit par une conduite 3 débouchant dans l'enceinte 1 au voisinage de l'injecteur. En outre, et de préférence, la partie basse de la zone d'évaporateur comprend une plaque 29 sur laquelle les gouttes projetées par l'injecteur viennent s'écraser et se vaporiser très rapidement. On peut aussi prévoir un système mécanique de transport comme cela a été indiqué ci-dessus.

Dans une variante de réalisation également représentée, l'introduction de gaz vecteur est effectuée à une hauteur intermédiaire de l'enceinte de dépôt, comme cela est symbolisé par une conduite d'introduction 30, pour introduire un double flux gazeux. Le premier flux gazeux (flèches 32) est dirigé vers le substrat et la conduite d'évacuation 28 et le deuxième (flèches 34) est dirigé vers un évent 36 dont l'orifice est voisin de la zone d'injection. L'intérêt du contre-flux 34 est que, si le solvant de la solution 11 contenant les précurseurs est très volatil, une évaporation partielle du solvant se produit entre l'injection par l'injecteur 14 et le choc des gouttelettes contre la plaque 29. Le contre-flux 34 permet d'évacuer par l'évent 36 une partie de ce solvant rapidement évaporé et de réduire un éventuel effet néfaste d'un excès de solvant dans la zone de dépôt du côté du substrat 2.

De préférence, la zone située au voisinage immédiat de l'injecteur 14 est refroidie ou plutôt maintenue à la même température que celle du réservoir 10 pour éviter un échauffement de l'injecteur et du volume de liquide 11 en attente d'injection contenu dans la chambre d'admission de l'injecteur.

Des essais pratiques ont été effectués par le demandeur avec un système du type de oelui de la figure 3 (sans contre-flux) et ont donné les résultats suivants.

### Exemple 1 - Dépôt d'une couche de Y₂O₃.

Le précurseur était un tétraméthylheptanedionate d'yttrium ou Y(tmhd)₃ en solution dans de I'éthanol (20 mg/ml). Le réservoir 10 était à 2 fois la pression atmosphérique (2x10⁵ pascals). Le gaz imposant la pression étant de l'azote.

La pression dans le réacteur 21 était de 10³ pascals. Le gaz vecteur était de l'air à un débit de 400 cm³/mn. La température du porte substrat était de 820°C.

On a procédé à 900 injections de gouttelettes de la solution à une fréquence d'une injection toutes les 1,5 s, la durée du dépôt étant 1430 s et le volume de liquide consommé étant de 3,5 cm³. On a alors obtenu sur un substrat de silicium ou d'acier inoxydable 200 nm de Y₂O₃ sans aucune fissure apparente détectable par microscopie électronique ou optique.

### Exemple 2 - Dépôt de ZrO₂ dopé Y

La solution contenue dans le réservoir 10 était Zr(tmhd)₄/Y(tmhd)₃ en solution dans du tétrahydrofurane. Les conditions étaient sensiblement identiques à celles de l'exemple 1 sauf que la fréquence d'injection était de deux par seconde et la durée de dépôt de 400 secondes. On a alors obtenu 250 nm de ZrO₂(Y) sans aucune fissure apparente en microscopie optique.

### Exemple 3 - Dépôt de YBa₂Cu₃O₇₋ₓ sur MgO

En ce cas, les précurseurs étaient Y(tmhd)3 (6,4 mg/ml), Ba(tmhd)₂ (13,5 mg/ml), Cu(tmhd)₂ (10,8 mg/ml) en solution dans du tétrahydrofuranne (une seule source). La pression dans le réservoir 10 était de 1,2 fois la pression atmosphérique (1,2x10⁵ P). Le gaz imposant la pression étant de l'azote. Le gaz vecteur était un mélange d'air (200 cm³/mn) et d'oxygène (300 cm³/mn). La température du porte substrat était de 900°C.

On a procédé à 400 injections à une fréquence de une injection par seconde pour une durée de dépôt de 400 s et un volume de liquide consommé de 5,1 ml.

Le substrat a ensuite été refroidi pendant 1/2 heure sous oxygène pur à la pression atmosphérique et on a obtenu un composé YBa₂Cu₃O₇ pur parfaitement texturé 001 (vérification par diffraction aux rayons X), d'une température critique de 70K.

### Exemple 4 - Dépôt d'oxyde de titane.

Le précurseur était de l'étoxyde de titane (Ti(OTE)₃) en solution dans du tétrahydrofuranne (dilution 1/5). La pression dans le réservoir 10 était de 1,5 fois la pression atmosphérique (1,5x10⁵ pascals). Le gaz imposant la pression étant de l'azote.
a) La pression dans le réacteur 21 était de 10³ P. Les gaz vecteurs étaient de l'azote à un débit de 25 cm³/mn et de l'oxygène à un débit de 25 cm³/mn. La température de l'évaporateur 20 était de 200°C et celle du porte substrat de 820°C. On a procédé à 300 injections de gouttelettes de la solution à une fréquence d'une injection par seconde. On a alors obtenu sur un substrat de silicium une couche d'oxyde de titane d'une épaisseur de 1000 nm.
b) Dans des conditions identiques, sauf en ce qui concerne les débits de gaz (respectivement 10 cm³/mn pour l'oxygène et 40 cm³/mn pour l'azote, on a obtenu avec 450 injections une couche d'oxyde de titane d'une épaisseur de 200 nm.

### Exemple 5 - Dépôt d'oxyde de tantale

Le précurseur était de l'étoxyde de tantale dilué dans du tétrahydrofuranne (dilution 1/20). La pression dans le réservoir 10 était de 2 fois la pression atmosphérique (2x10⁵ P). Le gaz imposant la pression étant de l'azote.
a) La pression dans le réacteur 21 était de 5x10³ P. Le gaz vecteur était de l'azote à un débit de 50 cm³/mn. La température de l'évaporateur 20 était de 200°C et celle du porte substrat de 500°C. On a procédé à 500 injections de gouttelettes de la solution à une fréquence d'une injection par seconde. On a alors obtenu sur un substrat de silicium une couche d'oxyde de titane d'une épaisseur de 200 nm.
b) La pression dans le réacteur 21 était de 2x10³ P. La pression dans le réservoir 10 était de 1,5 10⁵ P. Les gaz vecteurs étaient de l'azote à un débit de 50 cm³/mn et de l'oxygène à un débit de 20 cm³/mn. On a procédé à 600 injections de gouttelettes de la solution à une fréquence d'une injection par seconde. On a alors obtenu sur un substrat de silicium une couche d'oxyde de titane d'une épaisseur de 350 nm.

Les exemples ci-dessus utilisent un seul injecteur. Les inventeurs ont néanmoins fait des essais satisfaisants en prévoyant plusieurs injecteurs fonctionnant de façon légèrement décalée dans le temps et également de façon périodique.

L'invention est susceptible de nombreuses variantes, notamment en ce qui concerne la structure de l'enceinte de dépôt. Cette enceinte a été présentée comme verticale, le substrat étant en position basse. Elle pourrait être inversée ou horizontale. De même, dans le mode de réalisation particulier décrit, la vaporisation se fait principalement sur la plaque 29. Cette plaque pourrait être omise, la vaporisation se faisant naturellement ou, éventuellement, sur le séparateur poreux 26.

## Revendications

1. Procédé d'introduction dans une enceinte de dépôt chimique en phase vapeur d'éléments à déposer sur un substrat chaud ou de précurseurs de ces éléments, **caractérisé en ce qu'**il comprend les étapes suivantes :
maintenir le ou les précurseurs liquides ou en solution à une pression plus élevée que celle de l'enceinte,
injecter périodiquement dans l'enceinte de dépôt des gouttelettes de volume déterminé desdits précurseurs, et
entraîner vers le substrat les précurseurs à la température et à la pression de l'enceinte.

2. Procédé selon la revendication 1, **caractérisé en ce que** les gouttelettes injectées sont projetées sur une plaque chauffée où elles se volatilisent.

3. Dispositif d'introduction dans une enceinte de dépôt chimique en phase vapeur (1) de précurseurs du ou des éléments à déposer sur une substrat chaud, **caractérisé en ce qu'**il comprend :
au moins un réservoir (10) contenant le ou les précurseurs liquides ou en solution (11),
des moyens (12) pour maintenir le réservoir à une pression plus élevée que celle de l'enceinte,
au moins un injecteur associé à chaque réservoir muni de moyens de commande pour injecter périodiquement dans l'enceinte de dépôt des gouttelettes de volume déterminé des précurseurs, et
des moyens (3, 30, 28) pour entraîner les produits injectés vers un substrat situé dans l'enceinte de dépôt.

4. Dispositif selon la revendication 3, **caractérisé en ce qu'**il comprend un porte substrat chauffé.

5. Dispositif selon la revendication 3, **caractérisé en ce que** l'enceinte de dépôt comprend une plaque chauffée (29) sur laquelle sont projetées les gouttelettes.

6. Dispositif selon la revendication 3, **caractérisé en ce que** l'enceinte de dépôt est divisée en deux parties par un matériau poreux (26).

7. Dispositif selon la revendication 3, **caractérisé en ce que** l'enceinte de dépôt est divisée en une première partie constituant un évaporateur (20) et une deuxième partie à plus haute température constituant une chambre de dépôt (21).

8. Dispositif selon la revendication 7, **caractérisé en ce que** les moyens pour entrainer les produits injectés comprennent des moyens (30) d'injection de gaz vecteur situés dans une zone intermédiaire de la chambre de dépôt entre l'injecteur et le substrat pour entraîner, en association avec une pompe (28) située derrière le substrat, les précurseurs gazéifiés vers ce substrat et pour faire refluer les parties rapidement évaporées du solvant des gouttelettes vers un évent (36).

9. Dispositif selon la revendication 8, **caractérisé en ce qu'**il comprend des moyens mécaniques recevant les gouttelettes injectées et les transportant vers la chambre de dépôt.

## Patentansprüche

1. Verfahren zum Zuführen bzw. Einleiten von auf einem heißen Substrat abzuscheidenden Elementen oder Vorläufern dieser Elemente in einen Behälter bzw. Reaktor zur chemischen Abscheidung aus der Dampf- bzw. Gasphase, **dadurch gekennzeichnet, daß** das Verfahren die folgenden Stufen bzw. Schritte umfaßt:
der oder die flüssige(n) oder in Lösung befindliche(n) Vorläufer werden auf einem höheren Druck als der Druck in dem Abscheidungsbehälter bzw. -reaktor gehalten,
periodisch werden Tröpfchen vorgegebenen Volumens der genannten Vorläufer in den Abscheidungsbehälter bzw. -reaktor injiziert,
die Vorläufer werden bei der Temperatur und beim Druck des Behälters bzw. Reaktors zu dem Substrat transportiert.

2. Verfahren nach Anspruch 1, **dadurch gekennzeichnet, daß** die injizierten Tröpfchen auf eine erhitzte Platte gerichtet werden, wo sie verdampfen.

3. Vorrichtung zum Zuführen bzw. Einleiten von Vorläufern des oder der auf einem heißen Substrat abzuscheidenden Elements bzw. Elemente in einen Behälter bzw. Reaktor (1) zur chemischen Abscheidung aus der Dampf- bzw. Gasphase, **dadurch gekennzeichnet, daß** die Vorrichtung umfaßt:
wenigstens einen den oder die flüssigen oder in Lösung befindlichen Vorläufer (11) enthaltenden Vorratsbehälter (10),
Mittel (12), um den Vorratsbehälter auf einem höheren Druck als der Druck in dem Abscheidungsbehälter bzw. -reaktor zu halten,
wenigstens einen jeweils jedem Vorratsbehälter zugeordneten Injektor, der mit Steuermitteln versehen ist, um periodisch Tröpfchen vorbestimmten Volumens der Vorläufer in den Abscheidungsbehälter bzw. -reaktor zu injizieren,
Mittel (3, 30, 28) zum Transport der injizierten Stoffe zu einem in dem Abscheidungsbehälter bzw. -reaktor befindlichen Substrat.

4. Vorrichtung nach Anspruch 3, **dadurch gekennzeichnet, daß** sie einen heißen Substratträger aufweist.

5. Vorrichtung nach Anspruch 3, **dadurch gekennzeichnet, daß** der Abscheidungsbehälter bzw. -reaktor eine erhitzte Platte (29) aufweist, auf welche die Tröpfchen gerichtet werden.

6. Vorrichtung nach Anspruch 3, **dadurch gekennzeichnet, daß** der Abscheidungsbehälter bzw. -reaktor durch ein poröses Material (26) in zwei Abteile unterteilt ist.

7. Vorrichtung nach Anspruch 3, **dadurch gekennzeichnet, daß** der Abscheidungsbehälter bzw. -reaktor in ein erstes Abteil (20), das einen Verdampfer darstellt, und ein zweites, auf höherer Temperatur befindliches Abteil, das eine Abscheidungskammer darstellt, unterteilt ist.

8. Vorrichtung nach Anspruch 7, **dadurch gekennzeichnet, daß** die Mittel zum Transport der injizierten Stoffe Mittel (30) zur Injektion von Trägergas umfassen, die in einer Zwischenzone des Abscheidungsbehälters bzw. -reaktors zwischen dem Injektor und dem Substrat angeordnet sind, um in Verbindung mit einer hinter dem Substrat angeordneten Pumpe (28) die vergasten Vorläufer zu dem Substrat zu transportieren und den Rückfluß der schnell verdampften Teile des Lösungsmittels der Tröpfchen zu einem Abfluß (36) zu bewirken.

9. Vorrichtung nach Anspruch 8, **dadurch gekennzeichnet, daß** die Vorrichtung mechanische Mittel umfaßt, welche die injizierten Tröpfchen aufnehmen und zu der Abscheidungskammer transportieren.

## Claims

1. A method for introducing into a chemical vapor deposition chamber elements to be deposited over a hot substrate or precursors of said elements, **characterized in that** it comprises the following steps:
maintaining one or more liquid precursors or precursors in solution at a pressure higher than the pressure of the chamber,
periodically injecting in the deposition chamber droplets of said precursors having a determined volume, and
conveying toward the substrate the evaporated precursors at the temperature and pressure of the chamber.

2. The method of claim 1, **characterized in that** the injected droplets are projected against a heated plate where they are volatilized.

3. A device for introducing into a chemical vapor deposition chamber (1) precursors of one or more elements to be deposited on a hot substrate, **characterized in that** it includes:
at least one tank (10) containing one or more liquid precursors or precursors in solution (11),
means (12) for maintaining the tank at a pressure higher than the pressure of the chamber,
at least one injector associated with each tank provided with control means for periodically injecting into the deposition chamber precursor droplets having a determined volume, and
means (3, 30, 28) for conveying the injected products up to the substrate disposed in the deposition chamber.

4. The device of claim 3, **characterized in that** it includes a heated substrate holder.

5. The device of claim 3, **characterized in that** the deposition chamber includes a heated plate (29) on which the droplets are projected.

6. The device of claim 3, **characterized in that** the deposition chamber is partitioned into two portions by a porous material (26).

7. The device of claim 3, **characterized in that** the deposition chamber is partitioned into a first portion constituting an evaporator (20) and a second portion at a higher temperature constituting a deposition chamber (21).

8. The device of claim 7, **characterized in that** the means for conveying the injected products include means (30) for injecting carrier gases located in an intermediate area of the deposition chamber between the injector and the substrate for conveying, in combination with a pump (28) disposed behind the substrate, the gaseous precursors toward said substrate and for conveying back the fast evaporated portions of the droplet solvent to a gas vent (36)

9. The device of claim 8, **characterized in that** it includes mechanical means for receiving the injected droplets and for conveying them toward the deposition chamber.
